Europäisches Patentamt

European Patent Office

Office européen des brevets

(19)

(11) Veröffentlichungsnummer: **0 416 241 B1**

(12) **EUROPÄISCHE PATENTSCHRIFT**

(45) Veröffentlichungstag der Patentschrift: **30.11.94**

(51) Int. Cl.⁵: **C23C 14/35**, H01J 37/34

(21) Anmeldenummer: **90113047.6**

(22) Anmeldetag: **09.07.90**

(54) **Vorrichtung zum Beschichten eines Substrats.**

(30) Priorität: **07.09.89 DE 3929695**

(43) Veröffentlichungstag der Anmeldung:
**13.03.91 Patentblatt 91/11**

(45) Bekanntmachung des Hinweises auf die
Patenterteilung:
**30.11.94 Patentblatt 94/48**

(84) Benannte Vertragsstaaten:
**CH DE FR GB LI**

(56) Entgegenhaltungen:
**EP-A- 0 093 412**
**EP-A- 0 121 019**
**EP-A- 0 211 412**

**PATENT ABSTRACTS OF JAPAN vol. 7, no.
268 (C-197)(1413) 30. November 1983& JP-
A-58 147 558**

**PATENT ABSTRACTS OF JAPAN vol. 13, no.
516 (C-656)(3864) 17. November 1989& JP-
A-1208 463**

**PATENT ABSTRACTS OF JAPAN vol. 11, no.
369 (C-461)(2816) 2. Dezember 1987& JP-A-62
142 764**

(73) Patentinhaber: **LEYBOLD AKTIENGESELL-
SCHAFT
Wilhelm-Rohn-Strasse 25,
Postfach 1555
D-63450 Hanau (DE)**

(72) Erfinder: **Latz, Rudolf, Dr.
Spessartring 15
D-6054 Rodgau 2 (DE)**
Erfinder: **Scherer, Michael, Dr.
Im Heegholz 1a
D-6458 Rodenbach (DE)**

## Beschreibung

Die Erfindung betrifft eine Vorrichtung zum Beschichten eines Substrats, vorzugsweise mit Aluminiumoxid, mit einer Gleichstrom- und/oder einer Wechselstromquelle, die an eine in einer evakuierbaren Beschichtungskammer angeordnete Elektrode angeschlossen ist, die elektrisch mit einem Target in Verbindung steht, das zerstäubt wird und dessen zerstäubte Teilchen sich auf dem Substrat, beispielsweise einem Kunststoffteil, niederschlagen, wobei in die Beschichtungskammer ein Prozeßgas einbringbar ist und wobei toroidförmige Magnetfelder durch das Target hindurchgreifen, deren Feldlinien im Bereich der Magnetpole aus der Oberfläche des Targets austreten, wobei das Target eine im wesentlichen längliche, parallelepipede Form aufweist, deren einander diametral gegenüberliegenden Schmalen Stirnflächen bogenförmig abgerundet sind, und von einer Dunkelraumabschirmung umschlossen ist, deren dem Substrat zugewandter umlaufender Rand oder Stirnfläche geringfügig gegenüber der Vorderfläche des Targets zurückversetzt ist, wobei die in einer Kathodenwanne angeordnete, auf einem Joch gehaltene Magnetanordnung aus einer mittleren, sich in Targetlängsrichtung erstreckenden Reihe von schmalen Magneten und einer weiteren an der Randpartie des Jochs angeordneten endlosen Reihe von schmalen Magneten gebildet ist.

Es ist eine Kathodenzerstäubungsvorrichtung bekannt (DE-OS 27 07 144; Sloan Technology Corp.), mit einer eine zu zerstäubende, etwa rechteckige Fläche aufweisenden Kathode, einer aus drei zueinander parallelen Reihen von Magneten gebildeten Magneteinrichtung an der der zu zerstäubenden Fläche gegenüberliegenden Seite der Kathode zur Erzeugung magnetischer Kraftlinien, von denen wenigstens einige in die zu zerstäubende Fläche eintreten und aus ihr wieder heraustreten, und zwar an Schnittpunkten, die voneinander im Abstand liegen, zwischen denen die Kraftlinien kontinuierlich bogenförmige Segmente im Abstand von der zu zerstäubenden Fläche bilden, wobei letztere, zusammen mit den Kraftlinien, eine Begrenzung für einen geschlossenen Bereich bildet, wodurch ein tunnelförmiger Bereich gebildet wird, der über einen dadurch definierten Pfad auf der zu zerstäubenden Fläche liegt, sowie mit einer Anode in Nachbarschaft zur Kathode und mit einem Anschluß der Kathode und der Anode an eine Quelle elektrischen Potentials, wobei wenigstens die zu zerstäubende Fläche innerhalb eines evakuierbaren Behälters liegt.

Weiterhin ist eine Anordnung zum Beschichten eines Substrats mit Dielektrika bekannt (P 38 21 207.2, Leybold AG), die eine Gleichstromquelle aufweist, die mit einer Elektrode verbunden ist, die elektrisch mit einem Target in Verbindung steht, das zerstäubt wird und dessen zerstäubte Teilchen mit einem zugeführten Stoff eine Verbindung eingehen, die sich auf dem Substrat niederschlägt, wobei toroidförmige Magnetfelder durch das Target hindurchgreifen, deren Feldlinien im Bereich der Magnetpole aus der Oberfläche des Targets austreten. Bei dieser Anordnung ist eine Wechselstromquelle vorgesehen, deren Ausgangsspannung der Gleichspannung der Gleichstromquelle überlagert ist, wobei die elektrische Leistung der Wechselstromquelle, die der Elektrode zugeführt wird, 5 % bis 25 % der von der Gleichstromquelle der Elektrode zugeführten Leistung entspricht.

Weiter ist bereits eine Magnetron-Zerstäubungskathode für Vakuumbeschichtungsanlagen vorgeschlagen worden (DE 36 19 194, Leybold AG) mit einer kreisförmigen Targetplatte aus dem zu zerstäubenden Material, mit mindestens einem hinter der Targetplatte angeordneten Magnetsystem, das aus jeweils zwei ineinanderliegenden, in sich geschlossenen Reihen von Permanentmagneten besteht, wobei die Magnete einer jeden Reihe die gleiche Pol-Lage, die Magnete beider Reihen aber zueinander eine entgegengesetzte Pol-Lage aufweisen, derart, daß über der Targetplatte mindestens ein in sich geschlossener Tunnel aus von der einen Magnetreihe ausgehenden und zur anderen Magnetreihe zurückkehrenden magnetischen Feldlinien gebildet wird, und mit einer Antriebseinrichtung für die kontinuierliche Drehung des Magnetsystems um die Mittenachse der Targetplatte, wobei im Randbereich der Targetplatte ein erstes Magnetsystem für die Erzeugung eines ersten, zur Drehachse im wesentlichen konzentrischen, magnetischen Tunnels angeordnet ist, und zwischen der Drehachse und dem ersten Magnetsystem ein exzentrisch versetztes zweites Magnetsystem angeordnet ist, das einen zweiten magnetischen Tunnel erzeugt, der sich nur über einen Sektor der Targetplatte erstreckt, derart, daß bei einer gemeinsamen Drehung beider Magnetsysteme die Flächenelemente der Targetplatte dem Produkt aus Verweilzeit und Intensität dergestalt ausgesetzt sind, daß die Targetplatte im mittleren Bereich gleichmäßiger und am Rande stärker abgetragen wird, so daß ein gegenüber der Targetplatte angebrachtes Substratfeld gleichförmig beschichtet wird.

Schließlich ist es bekannt (Patent Abstracts of Japan, Bd. 7, No. 268, JP-A-58 147 558) das Target einer Vorrichtung zum Beschichten eines Substrats mit einer Dunkelraumabschirmung mit einem umlaufenden Rand zu versehen, der gegenüber der Vorderfläche des Targets geringfügig zurückversetzt ist.

Der vorliegenden Erfindung liegt nun die Aufgabe zugrunde, eine Anordnung zum stabilen Betrieb von komplizierten, reaktiven Sputterprozessen zu schaffen. Insbesondere sollen Verbindungs-schichten, wie beispielsweise $Al_2O_3$, $SiO_2$, $Si_3N_4$, ITO, $TiO_2$, $Ta_2O_5$ mit hoher Beschichtungsrate und Qualität herstellbar sein.

Diese Aufgabe wird erfindungsgemäß gelöst durch eine in einer mittleren Partie des Targets vorgesehene schlitzförmige Ausnehmung und eine in dieser Ausnehmung auf einem elektrischen Isolator fest angeordnete, ein zentrales Target bildenden Leiste aus einem metallischen Werkstoff, wobei zwischen Leiste und Target ein umlaufender Spalt vorgesehen ist. Vorzugsweise ist dabei die Leiste mit einem elektrischen Leiter auf ein von außen aufgeprägtes elektrisches Potential gelegt, wobei die in einer Kathodenwanne angeordnete, auf einem Joch gehaltene Magnetanordnung zwei Rundmagnete aufweist, wobei sich jeweils einer der Rundmagnete an jedem Ende der mittleren Reihe von Magneten befindet. Mit Vorteil ist ein Regler vorgesehen, der das Einleiten des Reaktiv-gases, z.B. $O_2$, über ein Ventil derart regelt, daß die Entladespannung auf einem vorgegebenen Sollwert gehalten ist, wobei der Regler die gemessene Ka-thodenspannung mit der vorgegebenen Sollspan-nung vergleicht und durch geregeltes Einleiten des Reaktivgases gleichhält.

Die Erfindung läßt die verschiedensten Ausführungsmöglichkeiten zu; eines davon ist in den an-hängenden Zeichnungen schematisch näher darge-stellt, und zwar zeigen:

Fig. 1 eine Sputteranlage mit einem zentral zu einem ersten oval ausgeformten Target zentral angeordneten Isolator mit einem auf diesem befestigten zweiten leistenförmigen Target,

Fig. 2 eine diagrammatische Darstellung der Kathodenspannung als Funktion des $O_2$-Flusses beim reaktiven Sputtern von $Al_2O_3$ und

Fig. 3 die Magnetanordnung gemäß Fig. 1 mit zwei Rundmagneten an den einan-der diametral gegenüberliegenden En-den des oval ausgeformten Magnet-jochs - in der Draufsicht

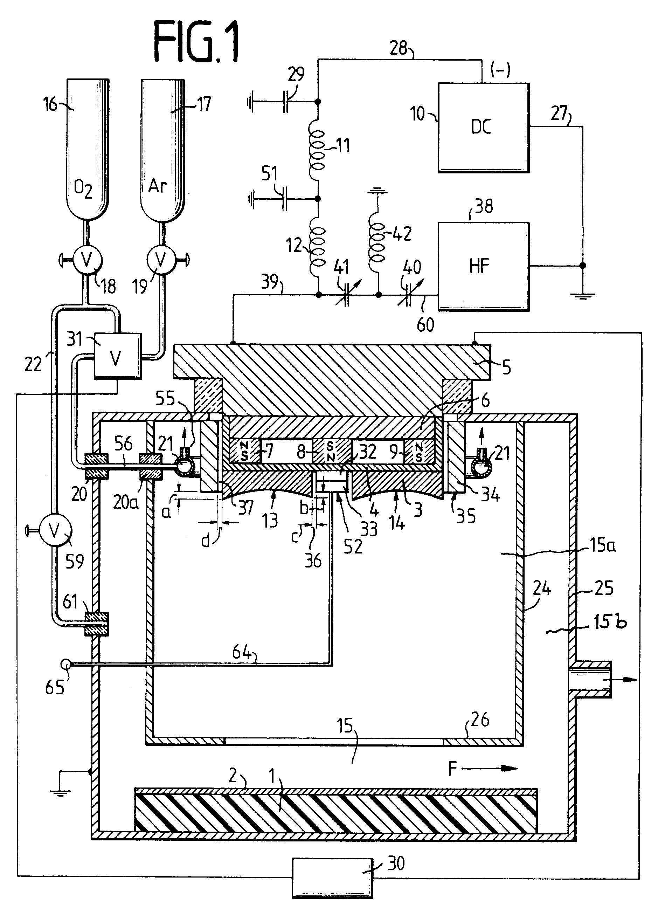

In der Zeichnung (Fig. 1) ist ein Substrat 1 dargestellt, das mit einer dünnen Metallschicht 2 versehen werden soll. Diesem Substrat 1 liegt ein Target 3 gegenüber, das zu zerstäuben ist. Das ringförmige Target 3, das einen Isolator 32 mit einem zentralen Target 33 umschließt, steht über ein im Schnitt U-förmiges Element 4 (einer sogenannten Kathodenwanne) mit einer Elektrode 5 in Verbindung, die auf einem Joch 6 ruht, das zwischen sich und dem Element 4 drei Reihen von Dauermagneten 7, 8, 9 einschließt. Die auf das Target 3 gerichteten Polaritäten der Pole der drei Dauermagnetreihen 7, 8, 9 wechseln sich ab, so daß jeweils die Südpole der beiden äußeren Dauermagnetreihen 7, 9 mit dem Nordpol der mittleren Dauermagnetreihe 8 ein etwa kreisbogenförmiges Magnetfeld durch das Target 3 bewirken. Dieses Magnetfeld verdichtet das Plasma vor dem Target 3, so daß es dort, wo die Magnetfelder das Maximum ihrer Kreisbögen besitzen, seine größte Dichte hat. Die Ionen im Plasma werden durch ein elektrisches Feld beschleunigt, das sich aufgrund einer Gleichspannung aufbaut, die von einer Gleichstromquelle 10 angegeben wird. Diese Gleichstromquelle 10 ist mit ihrem negativen Pol über zwei Induktivitäten 11, 12 und die elektrische Leitung 39 mit der Elektrode 5 verbunden. Das elektrische Feld steht senkrecht auf der Oberfläche des Targets 3 und beschleunigt die positiven Ionen des Plasmas in Richtung auf dieses Target. Hierdurch werden mehr oder weniger viele Atome oder Partikel aus dem Target 3 herausgeschlagen, und zwar insbesondere aus den Gebieten (bzw. Sputtergräben) 13, 14, wo die horizontale Komponente des Magnetfeldes ihr Maximum hat. Die zerstäubten Atome oder Partikel wandern in Richtung auf das Substrat 1 zu, wo sie sich als dünne Schicht 2 niederschlagen.

Die aus dem Target 3 herausgeschlagenen Metallpartikel reagieren in einem Raum 15 auf der Substratoberfläche mit bestimmten Gasen, die aus Gasbehältern 16, 17 über Ventile 18, 19, 31, 59 und einen Einlaßstutzen 20, 20a mit einer an diesen angeschlossenen Ringleitung 21 mit Düsen 55 mittels Gaszuführungsleitungen 23, 56 in diesen Raum 15a geleitet werden. Dieser Raum 15a wird durch zwei Behälter 24, 25 gebildet, von denen der eine Behälter 25 das Substrat 1 mitumfaßt, während der andere Behälter 24 vor dem Substrat 1 endet und eine Blende 26 bildet. Beide Behälter 24, 25 und damit auch das Substrat 1, das auf dem Boden des Behälters 25 ruht, liegen elektrisch auf Masse. An Masse liegt auch der zweite Anschluß 27 der Gleichstromquelle 10, deren erster Anschluß 28 außer an die Induktivitäten 11, 12 auch noch an Kondensatoren 29, 51 angeschlossen ist, die ihrerseits an Masse liegen.

Das Gas wird zweckmäßigerweise über ein die Kathode 5 umgebendes Gasverteilungssystem bzw. eine Ringleitung 21 mit Düsen 55 dem zweiten Behälter 24 zugeführt und gelangt darüber hinaus auch in den Zwischenraum 15b zwischen dem ersten und dem zweiten Behälter 24, 25.

Für die Steuerung der dargestellten Anordnung kann ein Prozeßrechner 30 vorgesehen werden, der Meßdaten verarbeitet und Steuerungsbefehle abgibt. In diesem Prozeßrechner 30 können beispielsweise die Werte des gemessenen Partialdrucks in der Prozeßkammer 25 eingegeben werden. Aufgrund dieser und anderer Daten kann er zum Beispiel den Gasfluß über das Piezoventil 31 regeln und die Spannung an der Kathode 5 einstellen. Der Prozeßrechner 30 ist auch in der Lage, alle anderen Variablen, zum Beispiel Kathodenstrom und magnetische Feldstärke, zu regeln. Da derartige Prozeßrechner bekannt sind, wird auf eine Beschreibung ihres Aufbaus verzichtet.

Wie Figur 1 zeigt, sind sowohl das U-förmige Element bzw. die Kathodenwanne 4 als auch das ringförmige Target 3 mit dem zentralen Target 33 von einer Dunkelfeldabschirmung 34 umschlossen, dessen substratseitige Stirnfläche 35 um das Maß a hinter das Target 3 zurückspringt (z. B. = 2 mm). Weiterhin befindet sich zwischen dem Isolator 32 bzw. dem zentralen Target 33 und der radial inneren Fläche des Targets 3 ein Ringspalt 36 (c = 1 mm) und ebenso ein Ringspalt 37 zwischen der radial äußeren Fläche des Targets 3 und der Innenseite der Dunkelfeldabschirmung 34 (d = 2 mm). Schließlich sei noch erwähnt, daß auch die substratseitige Stirnfläche 52 des stabförmigen zentralen Targets 33 gegenüber der kreisringförmigen Stirnfläche des Targets 3 um ein geringes Maß b (z. B. 1 mm) zurückversetzt ist.

Neben der DC-Stromquelle 10 ist außerdem eine HF-Stromquelle 38 an die Stromversorgungsleitung 39 bzw. 60 mit zwischengeschalteten Kondensatoren 40, 41 und einer Induktivität 42 vorgesehen, die auch die Einspeisung eines Wechselstroms in die Elektrode 5 ermöglicht.

Bei der Vorrichtung gemäß Figur 1 ist gewährleistet, daß eine reaktive Gasentladung in einer Argon-Reaktivgasatmosphäre vor der Magnetronkathode 5 mit einem Target 3 stabil brennt. Es kann sich dabei entweder um eine Gleichspannungsentladung, eine Hochfrequenzentladung oder eine Überlagerung von beiden handeln.

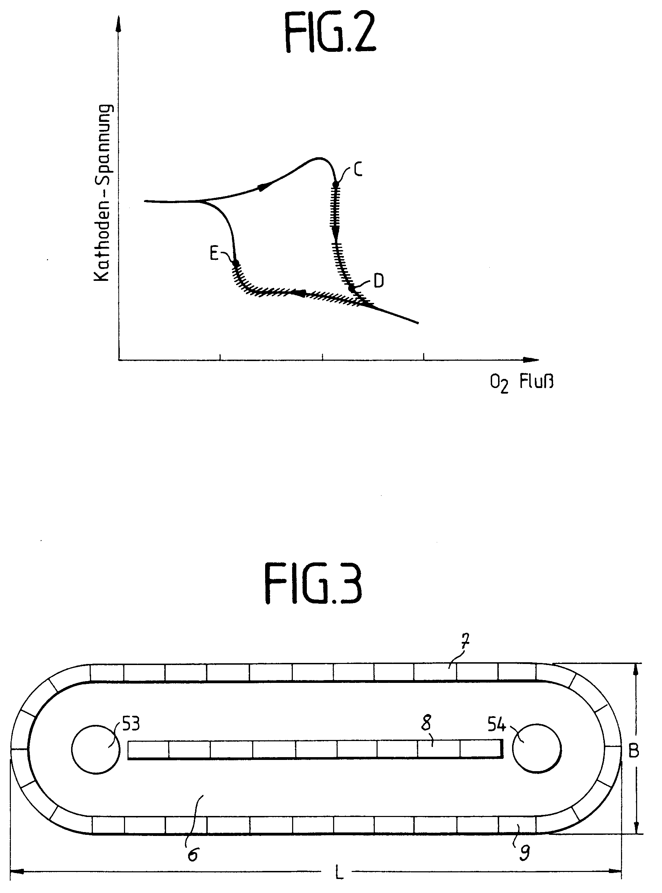

Das Target 3 ist (Figur 3) als Langtarget (Rechtecktarget) ausgeformt, dessen Enden bogenförmig abgerundet sind; d. h. daß das Langtarget im Grundriß die Form eines Ovals hat.

Diese Maßnahme ist insbesondere für eine reine DC-Entladung empfehlenswert. Dieses besonders geformte Target kann entweder auf rechteckige Standardkathodenwannen oder auf speziell mit Rundbögen hergestellte Kathodenwannen 4 aufgebracht werden.

Bei einer besonderen Ausführungsform ist das Magnetfeld derart geformt, daß der sputternde Bereich auf dem Target möglichst groß ist. Speziell für Langkathoden mit Rundbogentargets empfiehlt sich ein Magnetfeld, das von zwei Rundmagneten 53, 54 gebildet wird, die an den einander diametral gegenüberliegenden Enden des Jochs 48 angeordnet sind (Figur 3).

Das Magnetfeld zeichnet sich bei dieser Ausführungsform durch folgende Besonderheiten aus:

a) Die gewählten Magnete 7, 8, 9 sind sehr schmal (z. B. c = 5 mm) und haben eine hohe Magnetfeldstärke (Vacudym-Magnete).

b) An beiden Enden der Mittelmagnetreihe 8 sitzen zwei Rundmagnete 53, 54 geeigneter Größe und Stärke, so daß das Targetmaterial bei üblichen Entladespannungen bis zum Rande abgesputtert wird.

Beim reaktiven Sputtern an der Targetoberfläche bilden sich isolierende Beläge, die zu Instabilitäten der Entladung führen können.

Die Vermeidung solcher Instabilitäten ist beim reaktiven Sputtern unbedingt notwendig, jedoch erfahrungsgemäß kaum unter Produktionsbedingungen zu erreichen.

Dies ist insbesondere bei einigen kritischen, reaktiven Sputterprozessen (wie z. B. die Prozesse zum Herstellen von $Al_2O_3$, $SiO_2$, $Si_3N_4$, ITO, $TiO_2$, $Ta_2O_5$) der Fall, insbesondere wenn hohe Sputterraten erwünscht sind.

Betrachtet man die Kathodenspannung als Funktion des $O_2$-Flusses zum Beispiel beim reaktiven Sputtern von $Al_2O_3$, so zeigt sich der im Diagramm (Figur 2) dargestellte Verlauf.

Die Beschichtungsrate zeigt als Funktion des $O_2$-Flusses einen qualitativ ähnlichen Verlauf. Die Kurven zeigen eine unterschiedliche Abhängigkeit, je nachdem ob der $O_2$-Fluß bei der Aufnahme der Kurven von kleineren zu größeren Flüssen hin durchlaufen wird oder umgekehrt (Hysereseeffekt).

Im gestrichelten Bereich der beiden Kurven wird stöchiometrisches $Al_2O_3$ abgeschieden. Um eine hohe Sputterrate zu erzielen, wäre es wünschenswert, am Arbeitspunkt C zu sputtern. Dies ist jedoch ohne weitere Maßnahme unmöglich, da die $U = f(O_2)$-Abhängigkeit viel zu steil ist und der Prozeß innerhalb kurzer Zeit (<1 sec) wegdriftet.

Mittels einer speziellen Kathodenspannung-Reaktivgasflußregelung ist es möglich, selbst beim reaktiven Sputtern von $Al_2O_3$ den Arbeitspunkt bei C (im Diagramm) zu stabilisieren.

Unter Beachtung aller Maßnahmen kann sowohl beim reinen HF-Sputtern als auch beim überlagerten HF + DC-Sputtern ein $Al_2O_3$-Reaktivprozeß am Arbeitspunkt C über Stunden stabil aufrecht erhalten werden. Dabei sind Sputterraten von 30 A/sec und mehr ohne weiteres erzielbar.

Um ein schnelleres Regelverhalten zu gewährleisten, können beim Regeln zwei Kennlinienverhalten vorgeben werden:

a) ansteigende Kennlinie

b) abfallende Kennlinie

Um die Trägheit bei der Zufuhr des Reaktivgases möglichst klein zu halten, wird

1. ein Piezoventil 31 verwendet,

2. das Rohrstück 56 zwischen Piezoventil 31 und Austrittsöffnung 55 des Gases möglichst kurz gehalten und

3. der Durchmesser des Rohrstücks 56 bzw. der Ringleitung 21 nicht zu klein gewählt (>5 mm).

Das Arbeitsgas Argon kann entweder über die gleiche Leitung 56 zugeführt werden wie das Reaktivgas oder im Falle von In-line-Anlagen getrennt, z. B. außerhalb des Abschirmkastens 24 über eine zusätzliche Leitung.

Auflistung der Einzelteile

| 1 | Substrat |
|---|---|
| 2 | Schicht |
| 3 | Target |
| 4 | U-förmiges Element, Kathodenwanne |
| 5 | Elektrode |
| 6 | Joch |
| 7 | Dauermagnet |
| 8 | Dauermagnet |
| 9 | Dauermagnet |
| 10 | Gleichstromquelle |
| 11 | Induktivität |
| 12 | Induktivität |
| 13 | Sputtergraben (Gebiet) |
| 14 | Sputtergraben (Gebiet) |
| 15, 15a, 15b | Raum, Beschichtungskammer |
| 16 | Gasbehälter |
| 17 | Gasbehälter |
| 18 | Ventil |
| 19 | Ventil |
| 20, 20a | Einlaßstutzen |
| 21 | Ringleitung mit Düsen |
| 22 | Gaszuführungsleitung |
| 23 | Gaszuführungsleitung |
| 24 | Behälter |
| 25 | Behälter, Prozeßkammer |
| 26 | Blende |
| 27 | elektrischer Anschluß (Masse-Leitung) |
| 28 | elektrischer Anschluß |
| 29 | Kondensator |
| 30 | Prozeßrechner |
| 31 | Ventil, Piezoventil |
| 32 | Isolator |
| 33 | Target, zentrales Target |
| 34 | Dunkelfeldabschirmung |
| 35 | Stirnfläche |
| 36 | Ringspalt |
| 37 | Ringspalt |
| 38 | HF-Stromquelle |
| 39 | Stromversorgungsleitung |
| 40 | Kondensator |
| 41 | Kondensator |
| 42 | Widerstand, Induktivität |
| 48 | Joch |
| 50 | Welle |
| 51 | Kondensator |
| 52 | substratseitige Stirnfläche |
| 53 | Rundmagnet |
| 54 | Rundmagnet |
| 55 | Düse, Austrittsöffnung |
| 56 | Rohrstück |
| 57 | Gaszuführungsleitung |
| 58 | Zapfen |
| 59 | Ventil |
| 60 | Anschluß |
| 61 | Einlaßstutzen |

## Patentansprüche

1. Vorrichtung zum Beschichten eines Substrats (1), vorzugsweise mit Aluminiumoxid, mit einer Gleichstrom- und/oder einer Wechselstromquelle (10 bzw. 38), die an eine in einer evakuierbaren Beschichtungskammer (15, 15a) angeordnete Elektrode (5) angeschlossen ist, die elektrisch mit einem Target (3) in Verbindung steht, das zerstäubt wird und dessen zerstäubte Teilchen sich auf dem Substrat (1), beispielsweise einem Kunststoffteil, niederschlagen, wobei in die Beschichtungskammer (15, 15a) ein Prozeßgas einbringbar ist und wobei toroidförmige Magnetfelder durch das Target (3) hindurchgreifen, deren Feldlinien im Bereich der Magnetpole (7, 8, 9) aus der Oberfläche des Targets (3) austreten, wobei das Target (3) eine im wesentlichen längliche, parallelepipede Form aufweist, deren einander diametral gegenüberliegenden schmalen Stirnflächen nach Art eines Ovals bogenförmig abgerundet sind, und von einer Dunkelraumabschirmung (34) umschlossen ist, deren dem Substrat (1) zugewandter umlaufender Rand oder Stirnfläche (35) geringfügig gegenüber der Vorderfläche des Targets (3) zurückversetzt ist, wobei die in einer Kathodenwanne (4) angeordnete, auf einem Joch (6) gehaltene Magnetanordnung aus einer mittleren, sich in Targetlängsrichtung erstreckenden Reihe von schmalen Magneten (8) und einer weiteren an der Randpartie des Jochs (6) angeordneten endlosen Reihe von schmalen Magneten (7, 9) gebildet ist, **gekennzeichnet durch** eine in einer mittleren Partie des Targets (3) vorgesehene schlitzförmige Ausnehmung und eine in dieser Ausnehmung auf einem elektrischen Isolator (32) fest angeordnete, ein zentrales Target (33) bildenden Leiste aus einem metallischen Werkstoff, wobei zwischen Leiste (33) und Target (3) ein umlaufender Spalt (36) vorgesehen ist.

2. Vorrichtung nach Anspruch 1, **dadurch gekennzeichnet,** daß die Leiste (33) mit einem elektrischen Leiter (64) auf ein von außen aufgeprägtes elektrisches Potential (65) gelegt ist.

**3.** Vorrichtung nach den Ansprüchen 1 und 2, **dadurch gekennzeichnet**, daß die in einer Kathodenwanne (4) angeordnete, auf einem Joch (6) gehaltene Magnetanordnung zwei Rundmagnete (53, 54) aufweist, wobei sich jeweils einer der Rundmagnete (53, 54) an jedem Ende der mittleren Reihe von Magneten (8) befindet.

**4.** Vorrichtung nach den Ansprüchen 1 bis 3, gekennzeichnet durch einen Regler (30), der das Einleiten des Reaktivgases, z.B. $O_2$, über ein Ventil (31) derart regelt, daß die Entladespannung konstant bleibt.

## Claims

**1.** Apparatus for coating a substrate (1), preferably with aluminium oxide, having a direct-current and/or an alternating-current source (10 or 38, respectively) connected to an electrode (5) which is disposed in an evacuable coating chamber (15, 15a) and is electrically connected to a target (3) which is sputtered and whose sputtered particles are deposited on the substrate (1), for example a plastics part, in which apparatus a process gas can be introduced into the coating chamber (15, 15a) and toroidal magnetic fields whose field lines emerge from the surface of the target (3) in the region of the magnet poles (7, 8, 9) act through the target (3), in which apparatus the target (3) has an essentially elongated parallelepiped shape whose mutually diametrically opposite narrow end faces are rounded off in an arc-shaped manner in the fashion of an oval, and is enclosed by a dark-room screen (34) whose circumferential edge adjacent to the substrate (1) or end face (35) is slightly set back with respect to the front face of the target (3), and in which apparatus the magnet arrangement, which is disposed in a cathode cradle (4) and held on a yoke (6) is formed from a central series of narrow magnets (8) extending in the longitudinal direction of the target and a further endless series of narrow magnets (7, 9) disposed in the peripheral region of the yoke (6), characterized by a slot-type recess provided in a central region of the target (3) and a strip which is firmly mounted in said recess on an electrical insulator (32) and forms a central target (33) and which is composed of a metallic material, a circumferential gap (36) being provided between strip (33) and target (3).

**2.** Apparatus according to Claim 1, characterized in that the strip (33) is connected by means of an electrical conductor (64) to an externally applied electrical potential (65).

**3.** Apparatus according to Claims 1 and 2, characterized in that the magnet arrangement, which is disposed in a cathode cradle (4) and held on a yoke (6) comprises two round magnets (53, 54), one of the round magnets (53, 54) being situated in each case at each end of the central row of magnets (8).

**4.** Apparatus according to Claims 1 to 3, characterized by a controller (30) which controls the introduction of the reactive gas, for example $O_2$, via a valve (31) in such a way that the discharge voltage remains constant.

## Revendications

**1.** Appareil pour le revêtement d'un substrat (1), de préférence avec de l'oxyde d'aluminium, comprenant une source de courant continu et/ou une source de courant alternatif (10, ou respectivement 38) qui est raccordée à une électrode (5) agencée dans une chambre de revêtement (15, 15a) susceptible d'être évacuée, ladite électrode étant reliée électriquement à une cible (3) qui est pulvérisée et dont les particules pulvérisées se déposent sur le substrat (1), par exemple une pièce en matière plastique, un gaz de traitement pouvant être introduit dans la chambre de revêtement (15, 15a), et la cible (3) étant traversée par des champs magnétiques de forme toroïdale dont les lignes de champ sortent dans la région des pôles magnétiques (7, 8, 9) hors de la surface de la cible (3), la cible (3) présentant une forme sensiblement allongée et parallélépipédique, dont les faces frontales étroites opposées diamétralement l'une à l'autre sont arrondies en forme d'arc à la manière d'un ovale, et la cible étant entourée d'un écran (34) formant chambre noire, dont la bordure ou la face frontale (35) périphérique dirigée vers le substrat (1) est légèrement en retrait par rapport à la surface antérieure de la cible (3), l'ensemble magnétique agencé dans une cuve de cathode (4) et maintenu sur un étrier (6) étant constitué par une rangée médiane d'aimants étroits (8) qui s'étend dans la direction longitudinale de la cible, et une seconde série sans fin d'aimants étroits (7, 9) agencée sur la partie de bordure de l'étrier (6), caractérisé par un évidement en forme de fente prévu à travers une partie centrale de la cible (3), et une barrette de matériau métallique, agencée solidairement dans cet évidement sur un isolateur électrique (32), ladite barrette formant une cible centrale (33), une fente périphérique (36) étant prévue entre la barrette (33) et la cible (3).

2. Appareil selon la revendication 1, caractérisé en ce que la barrette (33) est mise depuis l'extérieur sous un potentiel électrique marqué (65) au moyen d'une ligne électrique (64).

3. Appareil selon les revendications 1 et 2, caractérisé en ce que l'ensemble magnétique agencé dans une cuve de cathode (4) et maintenu sur un étrier (6) comprend deux aimants circulaires (53, 54), chacun des aimants circulaires (53, 54) étant situé aux deux extrémités de la rangée centrale d'aimants (8).

4. Appareil selon les revendications 1 à 3, caractérisé par un régulateur (30) qui régule l'introduction du gaz réactif, par exemple aux deux, via une valve (31), de telle manière que la tension de décharge reste constante.

FIG.1

# FIG.2

Kathoden-Spannung

$O_2$ Fluß

# FIG.3